# EUROPEAN PATENT APPLICATION

(11) **EP 4 797 324 A1**
(43) Date of publication of application: **26.08.2026**
(21) Application number: 24879559.3
(22) Date of filing: 01.10.2024
(51) Int. Cl.: H01L 21/68

(54) **ALIGNER AND SUBSTRATE PROCESSING SYSTEM**

(30) Priority: 17.10.2023 JP 2023178672
(71) Applicant: Sinfonia Technology Co., Ltd., Tokyo 105-8564 (JP)
(72) Inventor: OKAZAKI, Tomohiro, Tokyo 105-8564 (JP)
(74) Representative: Angerhausen, Christoph
(86) International application number: PCT/JP2024/035166
(87) International publication number: WO 2025/084133

(57) **Abstract**

Provided is a technology that makes it possible to correct the position of a tape frame on the basis of either a frame portion or a substrate. A controller 150 can perform position correction either by first position correction process that corrects the position of a frame portion F of a tape frame TF installed on a stage 100 on the basis of a captured image captured of the frame portion F by a camera 120 or second position correction process that corrects the position of a wafer W on a tape portion T of the tape frame TF installed on the stage 100 on the basis of a captured image captured of the wafer W by the camera 120.

## Description

### TECHNICAL FIELD

The present disclosure relates to an aligner that corrects a position of a tape frame, and a substrate processing system including the aligner.

### BACKGROUND

Patent Document 1 describes a device for measuring an amount of rotational misalignment of bonded substrates, which detects the amount of rotational misalignment between each substrate of a bonded substrates formed by stacking and bonding a plurality of disk-shaped substrates, such as semiconductor wafers, each having a notch formed on its outer edge. In the device described in Patent Document 1, a control target is the bonded substrates. An aligner that corrects the position of a tape frame as a control target having a frame portion and a tape portion formed inside the frame portion and having a substrate attached thereto is also known in the art.

### [Prior Art Document]

### Patent Document

Patent Document 1: Japanese Patent No. 5836223

However, the conventional aligner described above corrects the position of the tape frame based on the frame portion, and does not correct the position of the substrate attached to the tape portion. Therefore, if there is a misalignment between the frame portion and the substrate attached to the tape portion, when the tape frame whose position has been corrected by the aligner is delivered to a process apparatus, the substrate inside the tape frame may not fall within a field of view of a high-precision camera installed on the process apparatus side, and it is necessary to separately correct the position of the tape frame on the process apparatus side based on the substrate.

The present disclosure provides a technique capable of correcting a position of a tape frame based on either a frame portion or a substrate.

### SUMMARY

To achieve the above-described object, an aligner according to Claim 1 is an aligner for correcting a position of a tape frame having an annular frame portion on which a first detection portion is formed and a tape portion formed inside the frame portion and having attached thereto a disk-shaped substrate where a second detection portion is formed, including: a stage configured to mount the tape frame thereon; a camera configured to image a partial region on the stage as a camera field of view; and a controller, wherein the controller is configured to perform position correction by either a first position correction process of correcting a position of the frame portion based on a captured image obtained by using the camera to image the frame portion of the tape frame mounted on the stage, or a second position correction process of correcting a position of the substrate based on a captured image obtained by using the camera to image the substrate attached to the tape portion of the tape frame mounted on the stage.

In this way, the aligner according to Claim 1 can perform the position correction of the tape frame based on either the frame portion or the substrate.

Furthermore, in the aligner of Claim 1, the aligner according to Claim 2 further includes: a movement mechanism configured to be capable of moving the stage in an X direction, a Y direction, and a θ direction; and an illuminator configured to illuminate a region on the stage including the partial region, wherein when performing the position correction by the first position correction process, the controller is configured to move the stage by using the movement mechanism to a position where the first detection portion of the frame portion falls within the camera field of view, image the first detection portion by using the camera while illuminating the region with the illuminator, correct the position of the frame portion based on the captured image, and then move the tape frame by using the movement mechanism so that a center position of the frame portion after the position correction becomes a delivery position at which the tape frame is delivered, and when performing the position correction by the second position correction process, the controller is configured to move the stage by using the movement mechanism to a position where the second detection portion of the substrate falls within the camera field of view, image the second detection portion using the camera while illuminating the region with the illuminator, correct the position of the substrate based on the captured image, and then move the tape frame by using the movement mechanism so that a center position of the substrate after the position correction becomes a delivery position at which the tape frame is delivered.

As a result, regardless of whether the position correction of the tape frame is performed based on the frame portion or the substrate, the center position of the frame portion or the wafer after the position correction becomes the delivery position at which the tape frame is delivered. Therefore, it is possible to accurately deliver the tape frame.

Furthermore, in the aligner of Claim 2, in the aligner according to Claim 3, when performing the position correction by both the first position correction process and the second position correction process, the controller is configured to grasp a positional relationship between the frame portion on the tape frame and the substrate based on position information of the first detection portion of the frame portion obtained when the position of the frame portion is corrected by the first position correction process and position information of the second detection portion of the substrate obtained when the position of the substrate is corrected by the second position correction process.

As a result, the controller can grasp a state in which the substrate is attached to the tape portion of the tape frame.

To achieve the above-described object, a substrate processing system according to Claim 4, includes: the aligner of any one of Claims 1 to 3; a storage configured to store the tape frame; a process apparatus configured to perform a predetermined process on the substrate attached to the tape portion of the tape frame; and a transfer robot configured to perform a first transfer process of taking out and transferring the tape frame stored in the storage, mounting the tape frame on the stage of the aligner, receiving and transferring the tape frame whose position has been corrected by the aligner, and delivering the tape frame to the process apparatus, and a second transfer process of receiving the tape frame for which the substrate has been subjected to the predetermined process by using the process apparatus from the process apparatus, transferring the tape frame, mounting the tape frame on the stage of the aligner, receiving and transferring the tape frame whose position has been corrected by the aligner, and storing the tape frame in the storage, wherein the controller of the aligner corrects the position of the substrate by the second position correction process when the tape frame is mounted on the stage of the aligner while the transfer robot is performing the first transfer process, and corrects the position of the frame portion by the first position correction process when the tape frame is mounted on the stage of the aligner while the transfer robot is performing the second transfer process.

In this way, in the substrate processing system according to Claim 4, since the position correction based on the substrate has been already made when the process apparatus receives the tape frame, it is possible to for the process apparatus to eliminate b efforts to perform position correction again. Furthermore, the storage has already performed the position correction based on the frame portion at the time when it receives the tape frame. Therefore, it is possible to accurately store the tape frame in each stage of the storage.

### BRIEF DESCRIPTION OF DRAWINGS

FIG. 1 is a plan view showing a schematic configuration of a substrate processing system according to a first embodiment of the present disclosure.
FIG. 2 is a plan view showing a schematic configuration of an aligner included in the substrate processing system of FIG. 1.
FIG. 3 is a side view of the aligner of FIG. 2.
FIG. 4 is a plan view showing an example of a tape frame as a control target of the aligner of FIG. 2.
FIG. 5 is a block diagram showing a control configuration of the aligner of FIG. 2.
FIG. 6 is a flowchart showing a procedure of a first position correction process executed by the aligner of FIG. 2, particularly by a controller.
FIG. 7 is a diagram for explaining the first position correction process of FIG. 6.
FIG. 8 is a flowchart showing a procedure of a second position correction process executed by the aligner of FIG. 2, particularly by the controller.
FIG. 9 is a diagram for explaining the second position correction process of FIG. 8.
FIGS. 10A and 10B are diagrams for explaining a method of correcting a position of a tape frame by an aligner included in a substrate processing system according to a second embodiment of the present disclosure.
FIGS. 11A and 11B are diagrams for explaining a method of correcting a position of a tape frame by an aligner included in a substrate processing system according to a third embodiment of the present disclosure.
FIG. 12 is a plan view showing a schematic configuration of a substrate processing system according to a fourth embodiment of the present disclosure.
FIG. 13 is a plan view showing a schematic configuration of a substrate processing system according to a modification of the fourth embodiment.

### DETAILED DESCRIPTION

Embodiments of the present application will be described below in detail with reference to the drawings.

### (First Embodiment)

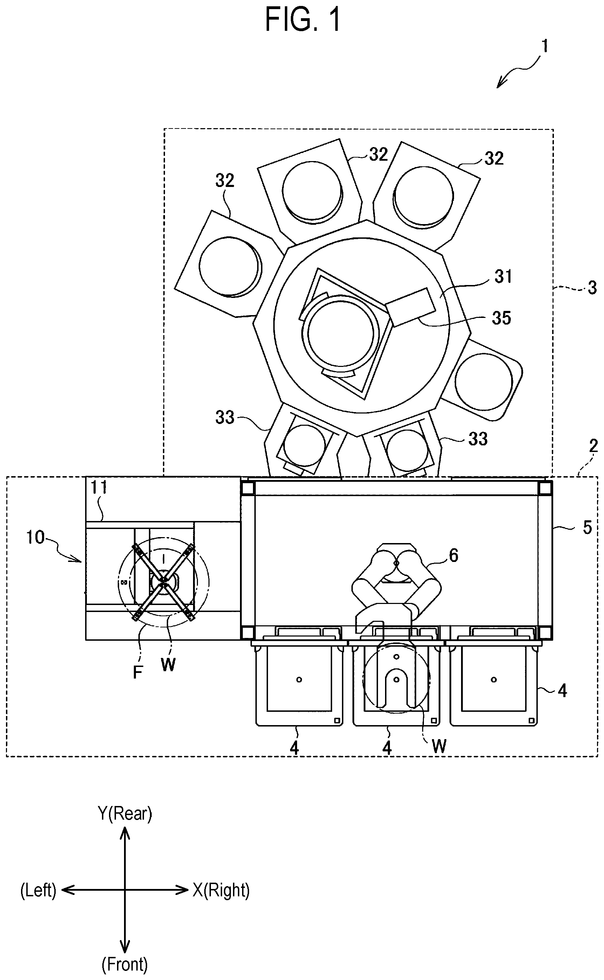

FIG. 1 shows the schematic configuration of a substrate processing system 1 according to a first embodiment of the present disclosure. The substrate processing system 1 of FIG. 1 is mainly constituted by an Equipment Front End Module (EFEM) 2 and a process apparatus 3. When referring to directions in each figure, directions of arrows shown in each figure will be used.

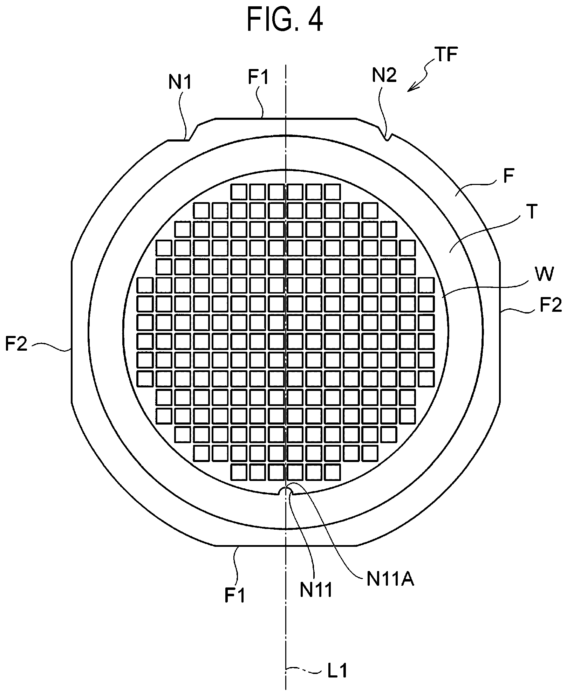

The EFEM 2 includes a plurality of (three in FIG. 1) load ports 4, a wafer transfer chamber 5, and an aligner 10. The load port 4 is provided adjacent to the front of the wafer transfer chamber 5, and is used to mount a FOUP (Front-Opening Unified Pod) that accommodates a plurality of tape frames TF *(see* FIG. 4). The load port 4 performs functions such as clamping, docking, and undocking the FOUP, opening and closing an FOUP door, and the like. A transfer robot 6 configured to transfer the tape frame TF into an internal space of the wafer transfer chamber 5 is arranged in the wafer transfer chamber 5. The transfer robot 6 takes out the tape frame TF from the FOUP and transfers the same to the aligner 10. Then, the transfer robot 6 takes out the tape frame TF whose position has been corrected by the aligner 10 from the aligner 10, and transfers the same to a delivery position in the process apparatus 3. Conversely, the transfer robot 6 receives the tape frame TF at the delivery position of the process apparatus 3 and transfers the same to the aligner 10. Then, the transfer robot 6 transfers the tape frame TF whose position has been corrected by the aligner 10 to the load port 4 and stores it in the FOUP.

The process apparatus 3 is provided adjacent to a rear surface of the wafer transfer chamber 5. The process apparatus 3 includes a transfer chamber 31, a process chamber 32 surrounding the transfer chamber 31, and a load lock chamber 33 similarly surrounding the transfer chamber 31 and located relatively closer to the wafer transfer chamber 5 than the process chamber 32. A transfer robot 35 is also provided above the transfer chamber 31 to transfer the tape frame TF installed in the load lock chamber 33 to the process chamber 32, and conversely, to transfer the tape frame TF installed in the process chamber 32 to the load lock chamber 33. Furthermore, in a case where the respective process chambers 32 are equipped with different functions, such as a film formation function, an etching function, and a cleaning function, and are configured to perform the respective functions in sequence, the transfer robot 35 also transfers the tape frame TF between the process chambers 32.

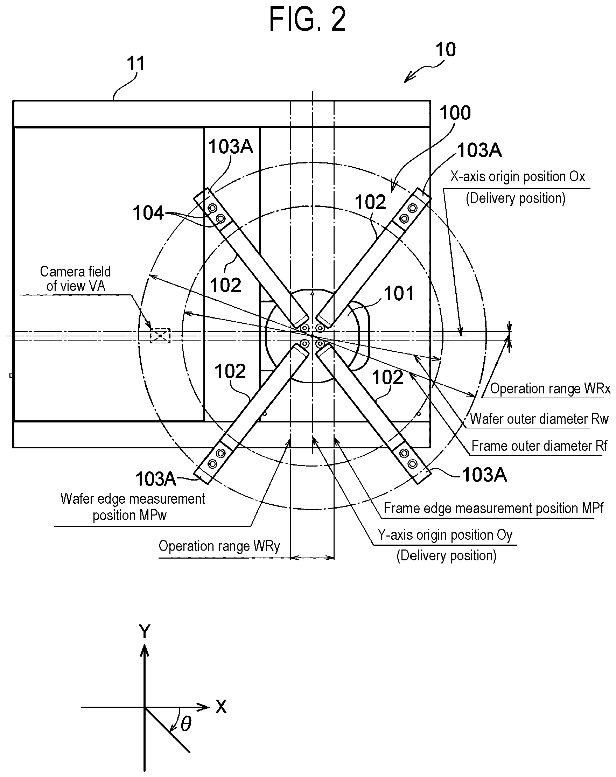

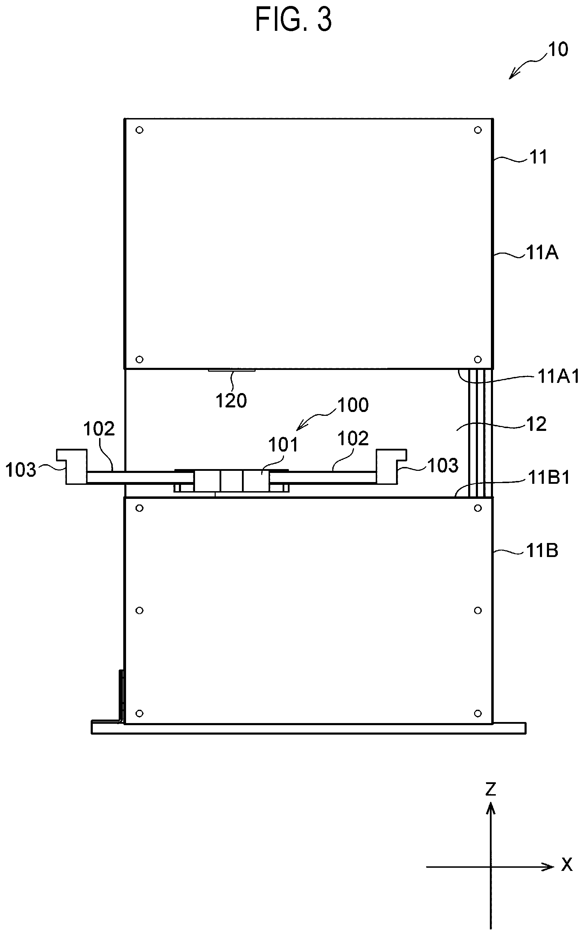

FIGS. 2 and 3 show the schematic configuration of the aligner 10. As shown in FIG. 2, the aligner 10 includes a main body housing 11. As shown in FIG. 3, the main body housing 11 includes an upper housing 11A and a lower housing 11B. A space 12 is formed between the upper housing 11A and the lower housing 11B. A stage 100 configured to mount a tape frame TF thereon is installed on an upper surface 11B1 of the lower housing 11B within the space 12.

FIG. 4 shows an example of the configuration of the tape frame TF. As shown in FIG. 4, the tape frame TF has an annular frame portion F and a disk-shaped tape portion T formed inside the frame portion F.

Notches N1 and N2 and linear portions F1 and F2, which are mainly used for position correction, are formed in the frame portion F. Positions and shapes of the notches N1 and N2 and the linear portions F1 and F2 are determined by, for example, semiconductor equipment and materials international (SEMI) standard.

A disk-shaped wafer W is attached to the tape portion T. A notch N11 is also formed in the wafer W. The position and shape of the notch N11 are also determined by the SEMI standard.

The tape frame TF does not initially have a wafer W attached thereto, and the wafer W is attached thereto later. Although the wafer W is attached by a machine, it is extremely difficult to attach the wafer W such that the center of the wafer W is perfectly aligned with the center of the tape frame TF, or to attach the wafer W such that a straight line L1 passing through the center of the tape frame TF and extending perpendicularly to the linear portion F1 accurately passes through an apex N11A of the notch N11 of the wafer W. For this reason, the wafer W after attachment usually contains a slight attachment error.

Returning to FIG. 2, the stage 100 includes a turntable 101, four arms 102 extending outward from the turntable 101, and support portions 103 *(see* FIG. 3) provided at tips of the respective arms 102. The support portions 103 support the frame portion F of the tape frame TF when the tape frame TF is mounted on the stage 100. Furthermore, a plurality of suction holes 104 are formed in the upper surface 103A of each support portion 103, and each suction hole 104 is in communication with a vacuum line (not shown) for sucking the tape frame TF. A valve and a vacuum source (e.g., a vacuum pump) are connected to the vacuum line. When a negative pressure is applied by the vacuum source while the frame portion F of the tape frame TF is supported on the upper surface 103A of each support portion 103, the frame portion F of the tape frame TF is sucked and held to the upper surface 103A of the support portion 103 via the suction holes 104. The method of holding the frame portion F of the tape frame TF is not limited to suction holding, and other holding methods such as friction holding may also be used.

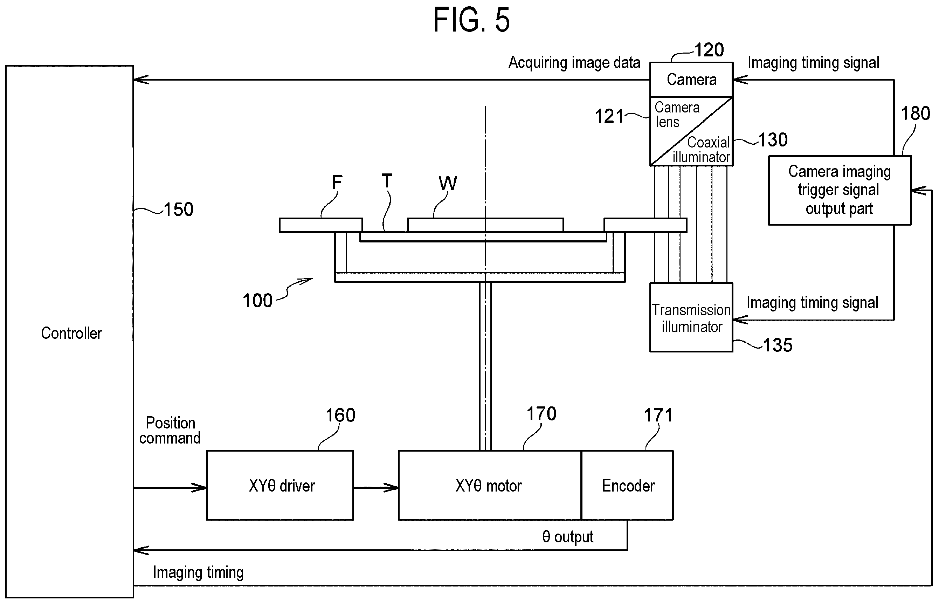

The turntable 101 is configured to rotate both clockwise and counterclockwise about an X-axis origin Ox and a Y-axis origin Oy. The rotation is performed by a predetermined angle by using, for example, a stepping motor. A rotation angle θ can be detected by counting the number of pulses input to the stepping motor. In this embodiment, the rotation angle θ is detected by using an encoder 171 (*see* FIG. 5). Furthermore, instead of using the stepping motor, the turntable 101 may be rotated by using a configuration in which a servo motor is combined with the encoder 171.

The turntable 101 is configured to be movable in both the X-axis direction and the Y-axis direction within predetermined operation ranges WRx and WRy, respectively. A known configuration may be used as the movement mechanism. For example, it is conceivable to use a mechanism configured by using two ball screws connected to the turntable 101 and extending in the X-axis direction and the Y-axis direction, respectively, and a motor configured to rotate the two ball screws. The motor used here may be a stepping motor, or another type of motor such as a servo motor or the like.

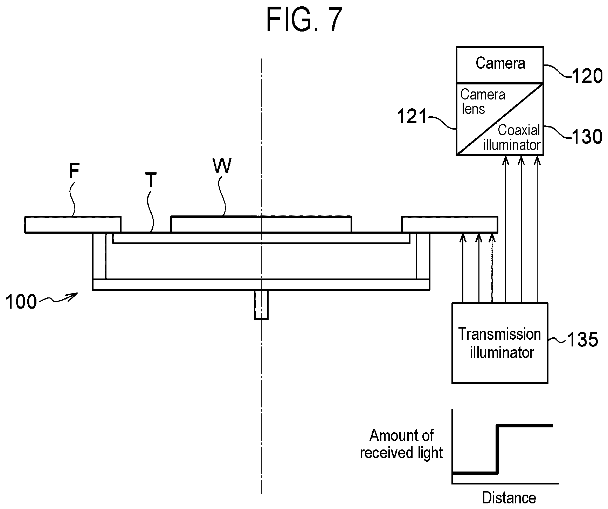

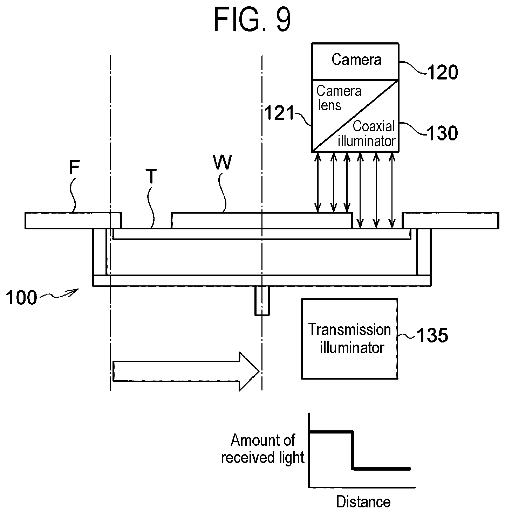

A camera 120 is fixedly installed on the lower surface 11A1 of the upper housing 11A. A camera lens 121 and a coaxial illuminator 130 *(see* FIG. 5) are provided adjacent to the camera 120. A positional relationship among the camera 120, the camera lens 121, and the coaxial illuminator 130 may be any relationship, and various positional relationship may be conceivable. For example, an embodiment of a positional relationship is conceivable in which the camera lens 121 is arranged below the camera 120 and the coaxial illuminator 130 is arranged to surround the camera lens 121. In this embodiment, the camera 120 is installed above a subject to face downward, which makes it possible to prevent dust from accumulating on the camera lens 121. A camera field of view VA shown in FIG. 2 indicates a range imaged by the camera 120. As will be described later with reference to FIGS. 7 and 9, the camera 120 is configured to image an outer edge of the frame portion F of the tape frame TF (a circumference formed by a frame outer diameter Rf) and an outer edge of the wafer W (a circumference formed by a wafer outer diameter Rw). Since the camera 120 is fixed, the stage 100 is moved in the X-axis direction, the Y-axis direction, and the θ direction, such that the outer edge of the frame portion F and the outer edge of the wafer W are included in the camera field of view VA.

FIG. 5 shows the control configuration of the aligner 10. In FIG. 5, the controller 150 is configured to control an operation of the aligner 10 and is constituted by, for example, an ASIC or a microcomputer equipped with a CPU. The controller 150 is built into the aligner 10. However, the present disclosure is not limited thereto. The controller 150 may be a PC provided outside the aligner 10.

The controller 150 outputs a position command to an XYθ driver 160 to specify the position of the stage 100. The XYθ driver 160 calculates a control amount for an XYθ motor 170 configured to move the stage 100 to the position specified by the position command, and outputs the calculated control amount to the XYθ motor 170. The XYθ motor 170 may be constituted by a single motor, or may be constituted by separate motors for the X-axis direction, the Y-axis direction, and the θ direction. The number of rotations and rotation direction of the XYθ motor 170 are detected by the encoder 171 and are output as rotation information (rotation angle θ).

The controller 150 outputs an imaging timing to a camera imaging trigger signal output part 180. In response to the received imaging timing, the camera imaging trigger signal output part 180 outputs an imaging timing signal, which is a camera imaging trigger signal, to the camera 120, the coaxial illuminator 130, and the transmission illuminator 135. The transmission illuminator 135 is installed on the upper surface 11B1 of the lower housing 11B at a position where it can illuminate a region including the camera field of view VA. The camera 120 images the camera field of view VA in response to receiving the imaging timing signal. At this time, only one of the coaxial illuminator 130 and the transmission illuminator 135 is turned on, and the other is turned off. Specifically, when the camera 120 is imaging the frame portion F of the tape frame TF, the transmission illuminator 135 is turned on *(see* FIG. 7), and when the camera 120 is imaging the wafer W of the tape frame TF, the coaxial illuminator 130 is turned on *(see* FIG. 9). Then, the camera 120 outputs the acquired image data to the controller 150. In addition, the controller 150 reads the θ output from the encoder 171 when the imaging timing is output, detects a rotation angle indicating how many degrees the stage 100 has rotated from the initial state in which the tape frame TF is mounted on the stage 100, associates the rotation angle with the image data, and stores the rotation angle and the image data in a memory (not shown).

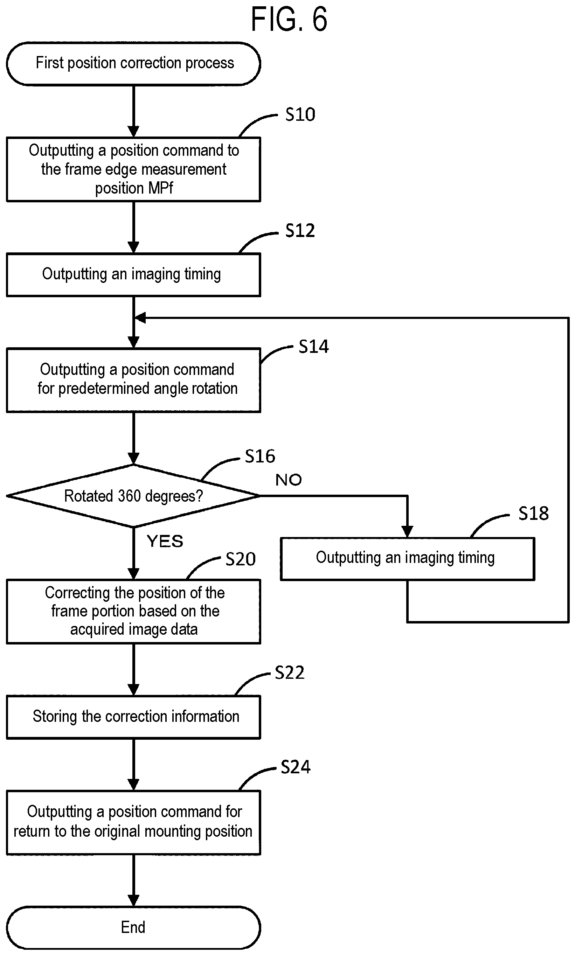

The control process executed by the aligner 10 configured as above will be described in detail with reference to FIGS. 6 to 9.

FIG. 6 shows the procedure of the first position correction process executed by the aligner 10, particularly the controller 150. The first position correction process is started when the tape frame TF is mounted on the stage 100. Hereinafter, in the description of the procedure of each process, a step will be represented as "S."

Referring to FIG. 6, first, the controller 150 outputs a position command to move the stage 100 to a frame edge measurement position MPf (*see* FIG. 2) (S10). Thus, the XYθ driver 160 outputs a control amount to the XYθ motor 170 to move the Y-axis origin Oy of the turntable 101 in the X-axis direction to the frame edge measurement position MPf. Therefore, the stage 100 moves to the frame edge measurement position MPf. Accordingly, the outer edge of the frame portion F of the tape frame TF falls within the camera field of view VA of the camera 120.

Next, the controller 150 outputs an imaging timing (S12). Thus, the transmission illuminator 135 is turned on, and a range of the camera field of view VA is imaged by the camera 120. The image data acquired by the imaging is output from the camera 120 to the controller 150 as described above, and the controller 150 stores the image data in the memory in association with the rotation angle θ detected as described above. FIG. 7 shows the camera 120 imaging the frame portion F of the tape frame TF. As shown in FIG. 7, an amount of light received by the camera 120 differs between the outside and inside of the outer edge of the frame portion F. Therefore, the controller 150 can determine a shape of the outer edge of the frame portion F based on the acquired image data.

Next, the controller 150 outputs a position command to rotate the stage 100 by a predetermined angle (S14). The predetermined angle is an angle required to move the region of the frame portion F, which currently falls within the camera field of view VA, to the next adjacent region. The current region and the next region may partially overlap with each other. The turntable 101 rotates by the predetermined angle in accordance with the position command.

Next, the controller 150 determines whether the stage 100 has rotated 360 degrees (S16), and if the stage 100 has not yet rotated 360 degrees (S16: NO), the controller 150 outputs an imaging timing (S18) in the same manner as in S12, and then returns the process to S14. Then, the controller 150 then images the range of the camera field of view VA while rotating the stage 100 by a predetermined angle at a time until the stage 100 has rotated 360 degrees, thereby acquiring image data.

When the stage 100 has rotated 360 degrees (S16: YES), the controller 150 corrects the position of the frame portion F based on the acquired image data (S20). The shape and the like of the tape frame TF are determined by the SEMI standard as described above, and therefore the outer edge shape of the frame portion F is known. Accordingly, by matching the outer edge shape of the frame portion F of the tape frame TF located at a correct position on the stage 100 with an outer edge shape of the frame portion F in the image data synthesized by stitching the acquired image data, the controller 150 can determine a current mounting state of the tape frame TF. In other words, since a center position of the tape frame TF at the correct position is located at (X-axis origin Ox, Y-axis origin Oy) on the turntable 101, and the notch N1 of the frame portion F is located at a predetermined position, by matching this with the outer edge shape of the frame portion F in the synthesized image data, the controller 150 can detect a difference between the center of the tape frame TF currently mounted on the stage 100 and (X-axis origin Ox, Y-axis origin Oy) on the turntable 101, and a rotational angle deviation indicating how much the tape frame TF has rotated from the correct position. Therefore, the controller 150 outputs a position command to the XYθ driver 160 to eliminate the detected difference and angle deviation. In response thereto, the position of the tape frame TF mounted on the stage 100 is corrected to the correct position based on the frame portion F. In this way, the position correction based on the frame portion F is performed based only on the notch N1. However, the present disclosure is not limited thereto. The position correction may be performed based only on the notch N2, or may be performed based on both the notches N1 and N2. In addition, the linear portions F1 and F2 may be additionally taken into consideration, or may be used alone to perform the position correction.

Next, the controller 150 stores the correction information (S22). As the correction information, for example, the center position of the tape frame TF may be stored as long as it is determined by a standard.

Furthermore, the controller 150 outputs a position command to the XYθ driver 160 to return the stage 100, which was moved to the frame edge measurement position MPf in S 10, to its original mounting position (S24), and then terminates the first position correction process. Thus, the tape frame TF whose position has been corrected based on the frame portion F is returned to the position at which the frame portion F has been delivered. However, the tape frame TF is not returned to the delivery position before the position correction as it is, but is returned so that the center position of the tape frame TF becomes the center of the delivery position. This is because the process in S20 corrects not only the deviation in the rotation angle but also the deviation in the center position of the tape frame TF.

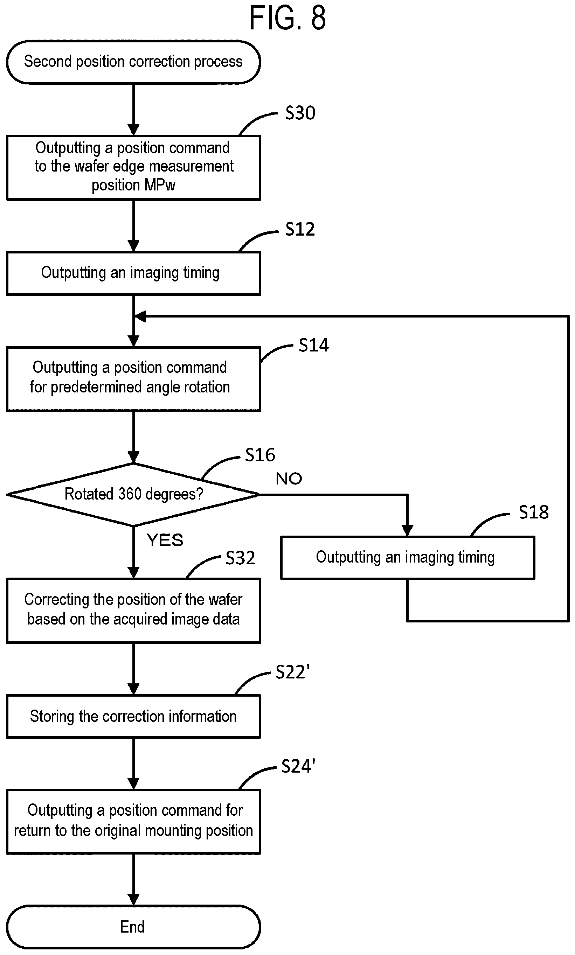

FIG. 8 shows the procedure of the second position correction process executed by the controller 150. The second position correction process is configured by partially modifying the first position correction process in FIG. 6. Therefore, the same processes are designated by the same reference numerals, and descriptions of those processes will be omitted as appropriate.

Referring to FIG. 8, first, the controller 150 outputs a position command to move the stage 100 to a wafer edge measurement position MPw *(see* FIG. 2) (S30). Thus, the XYθ driver 160 outputs a control amount to the XYθ motor 170 to move the Y-axis origin Oy of the turntable 101 in the X-axis direction to the wafer edge measurement position MPw, such that the stage 100 moves to the wafer edge measurement position MPw. Accordingly, the outer edge of the wafer W attached to the tape portion T of the tape frame TF falls within the camera field of view VA of the camera 120.

Next, the controller 150 performs the same processes as S12 to S18 in FIG. 6 on the outer edge of the wafer W. FIG. 9 shows the camera 120 imaging the wafer W. As shown in FIG. 9, an amount of light received by the camera 120 differs between the outside and inside of the outer edge of the wafer W, and therefore the controller 150 can determine a shape of the outer edge of the wafer W based on the acquired image data.

The controller 150 then corrects the position of the wafer W based on the acquired image data (S32). Since the shape of the wafer W is also determined by the SEMI standard as described above, the outer edge shape of the wafer W is also known. Accordingly, by matching the outer edge shape of the wafer W with the outer edge shape of the wafer W in the image data synthesized by stitching the acquired image data, the controller 150 determines a current mounting state of the wafer W and corrects this to a correct position based on the wafer W. At this time, the correction is made based on the notch N11 formed in the wafer W.

Next, the controller 150 stores the correction information (S22'). The correction information may be, for example, a center position (Oxw, Oyw) of the wafer W and the deviation angle between a line L1 passing through the center of the frame portion F and extending perpendicularly to the linear portion F1 and the apex N11A of the notch N11.

Furthermore, the controller 150 outputs a position command to the XYθ driver 160 to return the stage 100, which was moved to the wafer edge measurement position MPw in S30, to its original mounting position (S24'), and then terminates the second position correction process. Thus, the tape frame TF whose position has been corrected based on the wafer W is returned to the position where the tape frame TF has been delivered. However, the tape frame TF is not returned to the delivery position before the position correction as it is, but is returned so that the center position (Oxw, Oyw) of the wafer W becomes the center of the delivery position. This is because the process of S32 corrects not only the deviation in the rotation angle but also the deviation in the center position of the wafer W.

The second position correction process is executed when the transfer robot 6 takes out the tape frame TF from the FOUP mounted on the load port 4, transfers the tape frame TF to the aligner 10, and mounts the tape frame TF on the stage 100. The transfer robot 6 then receives the tape frame TF, whose position has been corrected based on the wafer W, from the stage 100 and transfers the tape frame TF to the process apparatus 3. On the other hand, conversely, the first position correction process is executed when the transfer robot 6 receives the tape frame TF from the process apparatus 3, transfers the tape frame TF to the aligner 10, and mounts the tape frame TF on the stage 100. The transfer robot 6 then receives the tape frame TF, whose position has been corrected based on the frame portion F, from the stage 100 and transfers the tape frame TF to the load port 4. In this way, since the position correction based on the wafer W has been already made when the process apparatus 3 receives the tape frame TF, it possible for the process apparatus 3 to eliminate efforts to perform position correction again. Furthermore, since the position correction based on the frame portion F has already been made when the load port 4 receives the tape frame TF, the tape frame TF can be accurately accommodated in each stage of the FOUP.

Furthermore, when both the first position correction process and the second position correction process are executed, the center position of the tape frame TF is stored in S22 of the first position correction process, and the center position (Oxw, Oyw) of the wafer W and the deviation angle between the straight line L1 and the apex N11A of the notch N11 is stored in S22' of the second position correction process. Therefore, the controller 150 can grasp a state in which the wafer W is attached to the tape portion T of the tape frame TF.

As described above, the aligner 10 in the present embodiment is the aligner configured to correct the position of the tape frame TF having the annular frame portion F where the notches N1 and N2 or the linear portions F1 and F2 are formed and the tape portion T formed inside the frame portion F and having attached thereto the disk-shaped wafer W where the notch N11 is formed, and includes: the stage 100 configured to mount the tape frame TF thereon; the camera 120 configured to image the partial region on the stage 100 as the camera field of view VA; and the controller 150, wherein the controller 150 performs position correction by either the first position correction process of correcting the position of the frame portion F based on the captured image obtained by using the camera 120 to image the frame portion F of the tape frame TF mounted on the stage 100, or the second position correction process of correcting the position of the wafer W based on the captured image obtained by using the camera 120 to image the wafer W attached to the tape portion T of the tape frame TF mounted on the stage 100.

In this way, the aligner 10 in the present embodiment can perform position correction of the tape frame TF based on either the frame portion F or the wafer W.

In addition, the aligner 10 further includes: the XYθ motor 170 configured to be capable of moving the stage 100 in the X direction, the Y direction, and the θ direction; and the illuminators 130 and 135 configured to illuminate the region on the stage 100 including the camera field of view VA, wherein when performing the position correction by the first position correction process, the controller 150 is configured to move the stage 100 by using the XYθ motor 170 to the position where the notches N1 and N2 or the linear portions F1 and F2 of the frame portion F fall within the camera field of view VA, image the notches N1 and N2 or the linear portions F1 and F2 by using the camera 120 while illuminating the region with the illuminators 130 and 135, correct the position of the frame portion F based on the captured image, and then move the tape frame TF by the XYθ motor 170 so that the center position of the frame portion F after the position correction becomes the delivery position at which the tape frame TF is delivered, and wherein when performing the position correction by the second position correction process, the controller 150 is configured to move the stage 100 by using the XYθ motor 170 to the position where the notch N11 of the wafer W falls within the camera field of view VA, image the notch N11 by using the camera 120 while illuminating the region with the illuminators 130 and 135, correct the position of the wafer W based on the captured image, and then move the tape frame TF by using the XYθ motor 170 so that the center position of the wafer W after the position correction becomes the delivery position at which the tape frame TF is delivered.

As a result, since regardless of whether the position correction of the tape frame TF is performed based on the frame portion F or the wafer W, the center position of the frame portion F or the wafer W after the position correction becomes the delivery position at which the tape frame TF is delivered, it is possible to accurately deliver the tape frame TF.

Furthermore, when performing the position correction by both the first position correction process and the second position correction process, the controller 150 grasps the positional relationship between the frame portion F on the tape frame TF and the wafer W based on the position information of the notch N1 of the frame portion F obtained when the position of the frame portion F is corrected by the first position correction process and the position information of the notch N11 of the wafer W obtained when the position of the wafer W is corrected by the second position correction process.

As a result, the controller 150 can grasp the state in which the wafer W is attached to the tape portion T of the tape frame TF.

As described above, the substrate processing system 1 in the present embodiment includes: the aligner 10; the FOUP configured to store the tape frame TF; the process apparatus 3 configured to perform the predetermined process on the wafer W attached to the tape portion T of the tape frame TF; and a transfer robot 6 configured to perform a first transfer process of taking out and transferring the tape frame TF stored in the FOUP, mounting the tape frame TF on the stage 100 of the aligner 10, receiving and transferring the tape frame TF whose position has been corrected by the aligner 10, and delivering the tape frame TF to the process apparatus 3, and a second transfer process of receiving the tape frame TF for which the wafer W has been subjected to the predetermined process by the process apparatus 3 from the process apparatus 3, transferring the tape frame TF, mounting the tape frame TF on the stage 100 of the aligner 10, receiving and transferring the tape frame TF whose position has been corrected by the aligner 10, and storing the tape frame TF in the FOUP, wherein the controller 150 of the aligner 10 corrects the position of the wafer W by the second position correction process when the tape frame TF is mounted on the stage 100 of the aligner 10 while the transfer robot 6 is performing the first transfer process, and corrects the position of the frame portion F by the first position correction process when the tape frame TF is mounted on the stage 100 of the aligner 10 while the transfer robot 6 is performing the second transfer process.

In this way, since the position correction based on the wafer W has already been made when the process apparatus 3 receives the tape frame TF, it is possible for the process apparatus 3 to eliminate the efforts to perform position correction again. Furthermore, since the position correction based on the frame portion F has already been made when the load port 4 receives the tape frame TF, it is possible to accurately store the tape frame TF in each stage of the FOUP.

### (Second Embodiment)

Next, a second embodiment of the present disclosure will be described. This embodiment differs from the first embodiment in that only one coaxial illuminator 130 is used. Therefore, the following description will focus on the differences, and descriptions of other parts will be omitted as appropriate. In addition, as a hardware of this embodiment, a hardware of the first embodiment shown in FIGS. 1 to 3 including the reference numerals is used as they are.

The frame portion F of the tape frame TF may have a high light reflectivity depending on a material thereof. When correcting the position of the tape frame TF having such a frame portion F with the high light reflectivity, the position correction for the tape frame TF can be performed based on either the frame portion F or the wafer W using only the coaxial illuminator 130 and the camera 120 without using the transmission illuminator 135.

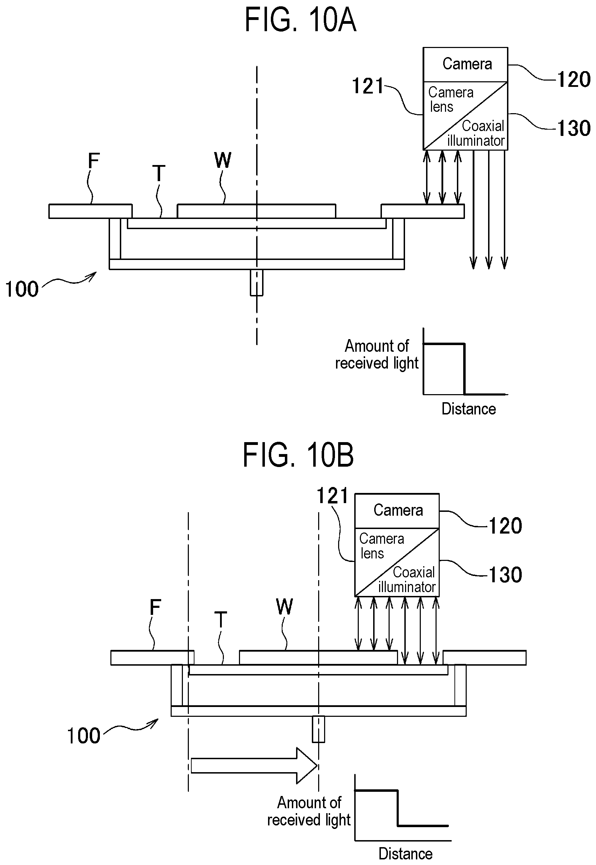

FIGS. 10A and 10B show this situation. FIG. 10A shows the camera 120 imaging the frame portion F of the tape frame TF, and FIG. 10B shows the camera 120 imaging the wafer W.

As shown in FIG. 10A, since the frame portion F of the tape frame TF has a high light reflectivity, an amount of received light received by the camera 120 differs between the outside and inside of the outer edge of the frame portion F, and therefore the controller 150 can determine the shape of the outer edge of the frame portion F based on the acquired image data. A graph of the amount of received light shown in FIG. 10A shows that the amount of received light is high inside the outer edge of the frame portion F and low outside the outer edge of the frame portion F, whereas a graph of the amount of received light shown in FIG. 7 shows the amount of received light in the opposite manner. However, since the amount of received light differs across the outer edge of the frame portion F, the controller 150 can determine the shape of the outer edge of the frame portion F based on the acquired image data. FIG. 10B is similar to FIG. 9, and therefore the description thereof will be omitted.

In this way, when the frame portion F with high light reflectivity is used as the tape frame TF, the transmission illuminator 135 may be omitted, and the position correction for the tape frame TF can be performed based on either the frame portion F or the wafer W by using only the coaxial illuminator 130 and the camera 120. This makes it possible to reduce a manufacturing cost of the aligner 10 as a whole.

### (Third Embodiment)

Next, a third embodiment of the present disclosure will be described. This embodiment differs from the first embodiment in that only one transmission illuminator 135 is used as the illuminator. Therefore, the following description will focus on the differences, and the descriptions of other parts will be omitted as appropriate. In addition, as a hardware of this embodiment, the hardware of the first embodiment shown in FIGS. 1 to 3 including the reference numerals is used as they are.

The tape portion T of the tape frame TF may have a high light transmittance depending on the material thereof. When correcting the position of the tape frame TF having such a tape portion T with a high light transmittance, the position correction for the tape frame TF can be performed based on either the frame portion F or the wafer W by using only the transmission illuminator 135 and the camera 120 without using the coaxial illuminator 130.

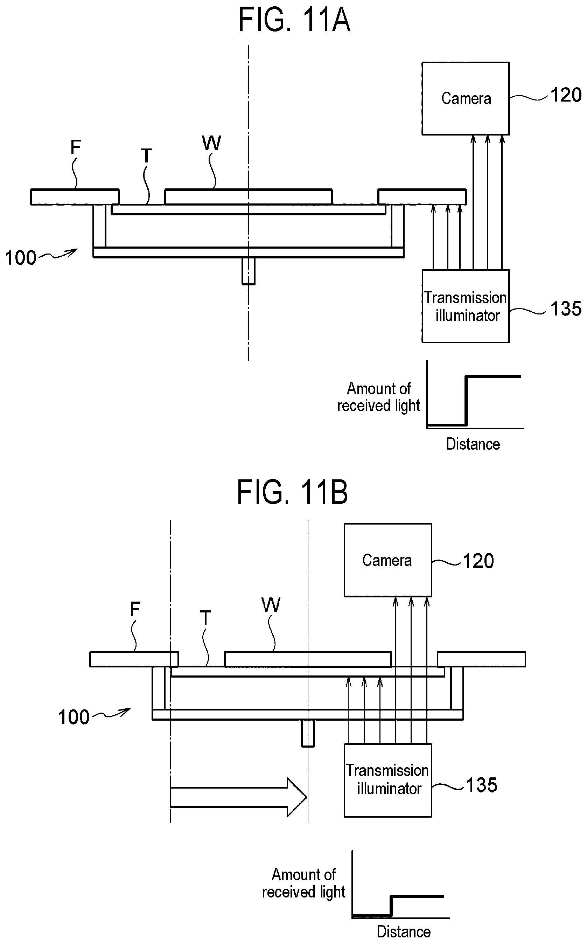

FIGS. 11A and 11B show this situation. FIG. 11A shows the camera 120 imaging the frame portion F of the tape frame TF, and FIG. 11B shows the camera 120 imaging the wafer W.

As shown in FIG. 11B, since the tape portion T of the tape frame TF has a high light transmittance, the amount of received light received by the camera 120 differs between the outside and inside of the outer edge of the wafer W, and therefore the controller 150 can determine the shape of the outer edge of the wafer W based on the acquired image data. A graph of the amount of received light shown in FIG. 11B shows that the amount of received light is low inside the outer edge of the wafer W and high outside the outer edge of the wafer W, whereas the graph of the amount of received light shown in FIG. 9 shows the amount of received light in the opposite manner. However, since the amount of received light differs across the outer edge of the wafer W, the controller 150 can determine the shape of the outer edge of the wafer W based on the acquired image data. FIG. 11A is similar to FIG. 7, and therefore the description thereof will be omitted.

In this way, when the tape portion T with high light transmittance is used as the tape frame TF, the coaxial illuminator 130 may be omitted, and the position correction for the tape frame TF can be performed based on either the frame portion F or the wafer W by using only the transmission illuminator 135 and the camera 120. This makes it possible to reduce the manufacturing cost of the aligner 10 as a whole.

### (Fourth Embodiment)

Next, a fourth embodiment of the present disclosure will be described. This embodiment mainly differs from the first embodiment in that the EFEM 2 is provided with a stocker 7 capable of temporarily storing tape frames TF. Therefore, the following description will focus on the differences, and the descriptions of other parts will be omitted as appropriate. In addition, as a hardware of this embodiment, the hardware of the first embodiment shown in FIGS. 1 to 3 including the reference numerals is used as they are.

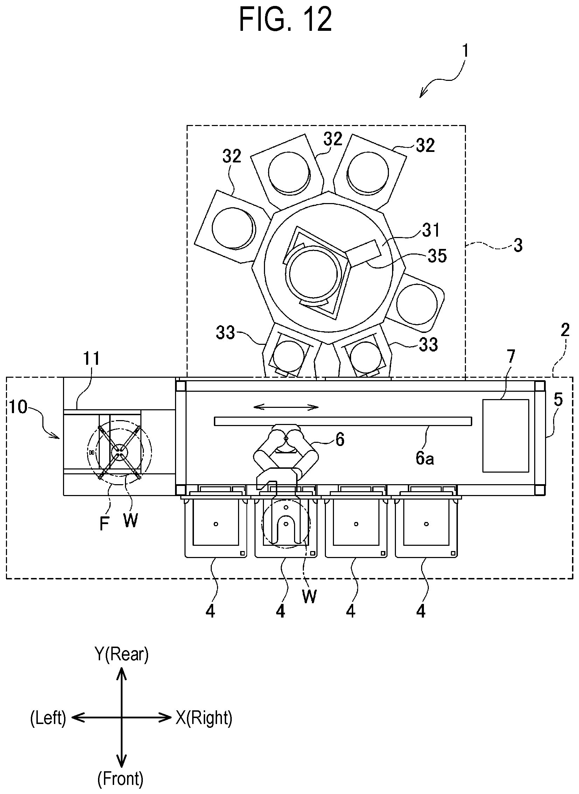

As shown in FIG. 12, the stocker 7 is arranged in the wafer transfer chamber 5. More specifically, the stocker 7 is arranged at the right end of the internal space of the wafer transfer chamber 5. The aligner 10 is arranged on the left side of the wafer transfer chamber 5. In other words, the aligner 10 and the stocker 7 are arranged separately on the left and right. Left and right arrangements of the aligner 10 and the stocker 7 in FIG. 12 may be reversed

The wafer transfer chamber 5 is provided with a rail 6a extending in the left-right direction. The rail 6a extends to the vicinity of a left end of the internal space of the wafer transfer chamber 5 near the stocker 7. The transfer robot 6 is configured to be movable left and right sides along the rail 6a by using a movement mechanism (not shown). The transfer robot 6 moves along the rail 6a and can load and unload tape frames TF into and out of the process apparatus 3, the FOUPs mounted on the load port 4, the stocker 7, and the aligner 10.

Further, in this embodiment, the number of load ports 4 included in the EFEM 2 is also different from that in the first embodiment. That is, the number of load ports 4 included in the EFEM 2 is three in the first embodiment, but four in this embodiment.

An example of the function of the stocker 7 will now be described. In the internal space of the FOUP, a plurality of support portions (not shown) configured to mount tape frames TF thereon are arranged one above another. The transfer robot 6 is also equipped with an arm (not shown) capable of supporting the tape frame TF from below, and load and unload the tape frame TF by inserting the arm into the internal space of the FOUP. A distance between the support portions of the FOUP is very small. When tape frames TF are mounted on adjacent two support portions respectively, the arm of the transfer robot 6 cannot be inserted between the two support portions. Therefore, when taking out the tape frames TF from the FOUP, the transfer robot 6 sequentially takes out the tape frames TF starting from those mounted on the lower support portions. Furthermore, when storing the tape frames TF in the FOUP, the transfer robot 6 sequentially mounts the tape frames TF on the support portions starting from upper support portions. In other words, the transfer robot 6 cannot randomly access the support portions of the FOUP. However, there is a demand for multiple tape frames TF stored in the FOUP to be transferred to the process apparatus 3 in a desired order regardless of their positions within the FOUP. There is also a demand for multiple tape frames TF taken out from the process apparatus 3 to be stored in the FOUP in a desired order regardless of the order in which processes were terminated in the process apparatus 3.

The stocker 7 is capable of temporarily storing a plurality of tape frames TF that have been taken out from the FOUP. Therefore, the plurality of tape frames TF stored in the stocker 7 can be transferred to the process apparatus 3 in a desired order. The stocker 7 is also capable of temporarily storing a plurality of tape frames TF that have been taken out from the process apparatus 3. Therefore, the plurality of tape frames TF stored in the stocker 7 can be accommodated in the FOUP in a desired order.

In this embodiment, the procedure in which the transfer robot 6 transfers the tape frame TF from the FOUP mounted on the load port 4 to the delivery position of the process apparatus 3 may be the following patterns A1 and A2. When the tape frame TF is transferred via the aligner 10, the aligner 10 corrects the position of the tape frame TF. At this time, at least the second position correction process is executed by the aligner 10. Both the first and second position correction processes may be executed.
(Pattern A1)
   Step 1: The tape frame TF is transferred from the FOUP to the aligner 10.
   Step 2: The tape frame TF is transferred from the aligner 10 to the process apparatus 3.
(Pattern A2)
   Step 1: The tape frame TF is transferred from the FOUP to the stocker 7.
   Step 2: The tape frame TF is transferred from the stocker 7 to the aligner 10.
   Step 3: The tape frame TF is transferred from the aligner 10 to the process apparatus 3.

Furthermore, the procedure in which the transfer robot 6 transfers the tape frame TF from the delivery position of the process apparatus 3 to the load port 4 and stores the tape frame TF in the FOUP may be the following patterns B1 to B4. When the tape frame TF is transferred via the aligner 10, the aligner 10 corrects the position of the tape frame TF. At this time, at least the first position correction process is executed by the aligner 10. Both the first and second position correction processes may be executed.
(Pattern B1)
   Step 1: The tape frame TF is transferred from the process apparatus 3 to the FOUP.
(Pattern B2)
   Step 1: The tape frame TF is transferred from the process apparatus 3 to the stocker 7.
   Step 2: The tape frame TF is transferred from the stocker 7 to the FOUP.
(Pattern B3)
   Step 1: The tape frame TF is transferred from the process apparatus 3 to the aligner 10.
   Step 2: The tape frame TF is transferred from the aligner 10 to the FOUP.
(Pattern B4)
   Step 1: The tape frame TF is transferred from the process apparatus 3 to the aligner 10.
   Step 2: The tape frame TF is transferred from the aligner 10 to the stocker 7.
   Step 3: The tape frame TF is transferred from the stocker 7 to the FOUP.

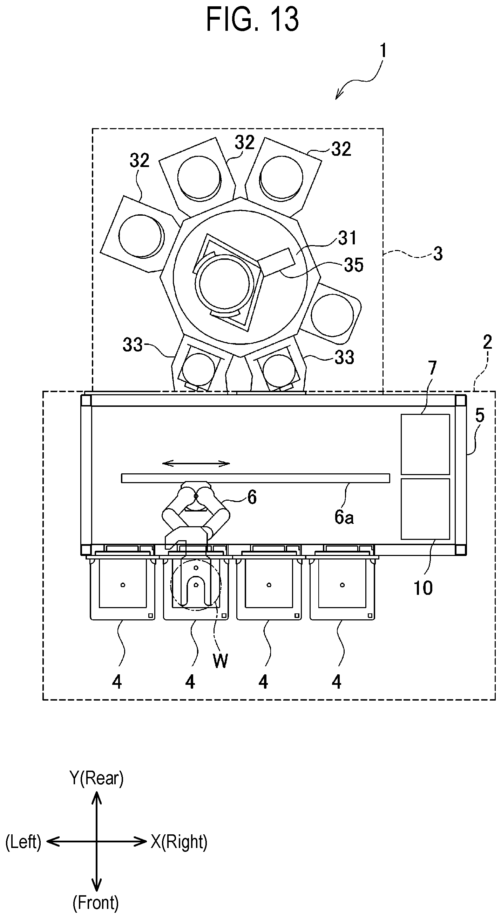

The present disclosure is not limited to the above-described embodiments, and various modifications may be made without departing from the spirit of the present disclosure.
(1) In each of the above-described embodiments, the FOUP is used as the container configured to accommodate the wafers W. However, other containers such as a front opening shipping box (FOSB) or the like may also be used.
(2) In each of the above-described embodiments, the present disclosure has been described by using the wafer W as an example of the substrate. However, the present disclosure is not limited thereto and may be applied to substrates such as glass substrates, resin substrates, and liquid crystal substrates.
(3) In each of the above-described embodiments, as the detection targets when performing the position correction, the notches N1 and N2 or the linear portions F1 and F2 are used in the frame portion F, and the notch N11 is used in the wafer W. However, the present disclosure is not limited thereto, and marks printed on the frame portion F or the wafer W may also be used.
(4) In each of the above-described embodiments, the camera 120 is installed above the position detection target to image the target from above. However, the installation position of the camera 120 is not limited to a position above the target, but may be a position below the target or a position on the lateral side of the target. The target may be imaged from above or below by using a mirror or the like.
(5) In each of the above-described embodiments, the camera 120 is used only to correct the position of the tape frame TF. In addition, the camera 120 may also be used to recognize a serial number printed on the tape frame TF or to analyze a two-dimensional code. This eliminates the efforts to install a dedicated camera configured to recognize the serial number or analyze the two-dimensional code, thereby reducing the manufacturing costs of the apparatus as a whole.
(6) In each of the above-described embodiments, the imaging timing signal received by the camera 120 is output by the camera imaging trigger signal output part 180 in response to the controller 150 outputting the imaging timing to the camera imaging trigger signal output part 180. In other words, the imaging timing signal is output mainly by the controller 150. However, the present disclosure is not limited thereto. In the present disclosure, the imaging timing signal may be output mainly by the encoder 171 and the imaging timing signal may be directly output to the camera 120 or the like whenever a predetermined rotation angle is detected , or the imaging timing may be output to the camera imaging trigger signal output part 180 whenever a predetermined rotation angle is detected, such that the outer edge of the frame portion F of the tape frame TF and the outer edge of the wafer W may be imaged without using the controller 150.
(7) In each of the above-described embodiments, the position correction based on the frame portion F of the tape frame TF is performed by detecting the outer edge shape of the frame portion F and then performing the position correction based on that outer edge shape.
   However, the present disclosure is not limited thereto. The position correction may also be performed by detecting the inner edge shape of the frame portion F and then performing the position correction based on the inner edge shape.
(8) In the fourth embodiment described above, the aligner 10 and the stocker 7 are arranged apart from each other in the left-right direction. However, the present disclosure is not limited thereto. For example, as shown in FIG. 13, the aligner 10 and the stocker 7 may be arranged adjacent to each other in the front-rear direction. In a case where the aligner 10 and the stocker 7 are arranged adjacent to each other in this way, it is possible to shorten a transfer time of the tape frame TF between the aligner 10 and the stocker 7.

### EXPLANATION OF REFERENCE NUMERALS

1: substrate processing system, 3: process apparatus (processing apparatus), 4: load port, 6: transfer robot (robot), 10: aligner, 100: stage, 120: camera, 130: coaxial illuminator (illuminator), 135: transmission illuminator (illuminator), 150: controller (control part), 170: XYθ motor (movement mechanism), N1, N2: notch (first detection portion), N11...notch (second detection portion), F: frame portion, F1, F2: linear portion (first detection portion), T: tape portion, TF: tape frame, VA: camera field of view, W: wafer

## Claims

1. An aligner for correcting a position of a tape frame having an annular frame portion on which a first detection portion is formed and a tape portion formed inside the frame portion and having attached thereto a disk-shaped substrate where a second detection portion is formed, comprising:
a stage configured to mount the tape frame thereon;
a camera configured to image a partial region on the stage as a camera field of view; and
a controller,
wherein the controller is configured to perform position correction by either a first position correction process of correcting a position of the frame portion based on a captured image obtained by using the camera to image the frame portion of the tape frame mounted on the stage, or a second position correction process of correcting a position of the substrate based on a captured image obtained by using the camera to image the substrate attached to the tape portion of the tape frame mounted on the stage.

2. The aligner of Claim 1, further comprising:
a movement mechanism configured to be capable of moving the stage in an X direction, a Y direction, and a θ direction; and
an illuminator configured to illuminate a region on the stage including the partial region,
wherein when performing the position correction by the first position correction process, the controller is configured to move the stage by using the movement mechanism to a position where the first detection portion of the frame portion falls within the camera field of view, image the first detection portion by using the camera while illuminating the region with the illuminator, correct the position of the frame portion based on the captured image, and then move the tape frame by using the movement mechanism so that a center position of the frame portion after the position correction becomes a delivery position at which the tape frame is delivered, and
when performing the position correction by the second position correction process, the controller is configured to move the stage by using the movement mechanism to a position where the second detection portion of the substrate falls within the camera field of view, image the second detection portion using the camera while illuminating the region with the illuminator, correct the position of the substrate based on the captured image, and then move the tape frame by using the movement mechanism so that the center position of the substrate after the position correction becomes a delivery position at which the tape frame is delivered.

3. The aligner of Claim 2, wherein when performing the position correction by both the first position correction process and the second position correction process, the controller is configured to grasp a positional relationship between the frame portion on the tape frame and the substrate based on position information of the first detection portion of the frame portion obtained when the position of the frame portion is corrected by the first position correction process and position information of the second detection portion of the substrate obtained when the position of the substrate is corrected by the second position correction process.

4. A substrate processing system, comprising:
the aligner of any one of Claims 1 to 3;
a storage configured to store the tape frame;
a process apparatus configured to perform a predetermined process on the substrate attached to the tape portion of the tape frame; and
a transfer robot configured to perform a first transfer process of taking out and transferring the tape frame stored in the storage, mounting the tape frame on the stage of the aligner, receiving and transferring the tape frame whose position has been corrected by the aligner, and delivering the tape frame to the process apparatus, and a second transfer process of receiving the tape frame for which the substrate has been subjected to the predetermined process by using the process apparatus from the process apparatus, transferring the tape frame, mounting the tape frame on the stage of the aligner, receiving and transferring the tape frame whose position has been corrected by the aligner, and storing the tape frame in the storage,
wherein the controller of the aligner corrects the position of the substrate by the second position correction process when the tape frame is mounted on the stage of the aligner while the transfer robot is performing the first transfer process, and corrects the position of the frame portion by the first position correction process when the tape frame is mounted on the stage of the aligner while the transfer robot is performing the second transfer process.
